# EUROPÄISCHE PATENTSCHRIFT

(11) **EP 0 879 303 B1**
(45) Veröffentlichungstag und Bekanntmachung des Hinweises auf die Patenterteilung: **24.05.2000**
(21) Anmeldenummer: 97914121.5
(22) Anmeldetag: 03.02.1997
(51) Int. Cl.: C23C 16/44, C23C 16/46, H01L 21/00

(54) **BESCHICHTUNGSAPPARATUR UND -VERFAHREN FÜR SUBSTRATE**
DEVICE AND PROCESS FOR COATING SUBSTRATES
DISPOSITIF ET PROCEDE DE REVETEMENT DE SUBSTRATS

(30) Priorität: 08.02.1996 DE 19604461
(43) Veröffentlichungstag der Anmeldung: 25.11.1998
(73) Patentinhaber: FORSCHUNGSZENTRUM JÜLICH GMBH, 52425 Jülich (DE)
(72) Erfinder: BONZEL, Hans, Paul, D-52355 Düren (DE); PIRUG, Gerhard, D-52441 Linnich (DE); VERHASSELT, Jörn, D-47533 Kleve (DE)
(86) Internationale Anmeldenummer: DE9700217
(87) Internationale Veröffentlichungsnummer: WO9729218

(56) Entgegenhaltungen:
- EP-A- 0 167 703
- DE-A- 4 030 675
- US-A- 5 268 202

## Beschreibung

Die Erfindung bezieht sich auf ein Verfahren und eine Vorrichtung zur Abscheidung einer Schicht auf einer Substratoberfläche mit mikroelektronischen Strukturen. Ein das Schichtmaterial enthaltendes Gas wird auf die Substratoberfläche geleitet. Das im Gas enthaltene Material scheidet sich als Schicht auf der Substratoberfläche ab.

Bekannt ist beispielsweise ein TEOS-Gasphasenreaktor, der bei ca. 970 -1100 K betrieben wird. Gasförmiges TEOS (Tetraethoxysilan) umströmt ein Substrat. Auf der Substratoberfläche scheidet sich dann eine Siliziumdioxidschicht ab. Gas und Substrat weisen während des Vorganges eine vergleichbare Temperatur auf.

Das bekannte Abscheidungsverfahren wird z. B. durchgeführt, um auf hochintegrierten Halbleiterbauelementen eine Passivierungsschicht aufzubringen.

Nachteilhaft wirken sich die hohen Temperaturen schädigend auf die auf dem Substrat vorhandenen Bauelementestrukturen aus.

Aus EP-A-0 167 703 ist eine Apparatur sowie ein entsprechendes Verfahren zur chemischen Vakuumabscheidung bekannt. Bei diesem Verfahren werden zwei Gase in der Nähe des gekühlten, zu beschichtenden Substrates derart gemischt, daß das erste Gas, welches das abzuscheidende Material aufweist und eine Temperatur unterhalb der Zersetzungstemperatur des abzuscheidenden Materials aufweist, durch das zweite so hoch erhitzte Gas durch Mischung auf solche Temperaturen erhitzt wird, daß es zur Zersetzung des abzuscheidenden Materials kommt.

Aufgabe der Erfindung ist die Schaffung eines Verfahrens sowie einer Vorrichtung zur Beschichtung von Substratoberflächen, bei denen im verminderten Umfang mikroelektronische Strukturen auf dem Substrat infolge des Beschichtungsvorgangs geschädigt werden, und welches auch eine kontinuierliche Beschichtung mehrerer Substrate ermöglicht.

Gelöst wird die Aufgabe durch ein Verfahren sowie durch eine Vorrichtung mit den Merkmalen des Haupt- sowie des Nebenanspruchs. Vorteilhafte Ausgestaltungen ergeben sich aus den Unteransprüchen.

Verfahrensgemäß wird eine Entkopplung der Gas- und Probentemperatur vorgenommen, so daß heißes Gas auf eine kühle Oberfläche mit mikroelektronischen Strukturen trifft. Der Temperaturunterschied ist insbesondere so gewählt, daß einerseits das Substrat kühl genug ist, um auf dem Substrat befindliche Strukturen zu erhalten und andererseits das Gas die für den Abscheidungsprozeß erforderliche Temperatur aufweist.

Erreicht wird dies beispielsweise durch Kühlung des Substrats unter Beibehaltung der erforderlichen Gaszersetzungstemperaturen. Alternativ wird erhitztes Gas in einen ansonsten ungeheizten Behälter eingeleitet, in dem das Substrat geeignet im Gasstrahl positioniert ist. Auf diese Weise bleibt die Substratoberfläche kühl im Vergleich zum Gas. Bauelementestrukturen bleiben so erheblich besser erhalten im Vergleich zum bekannten Verfahren.

In besonders vorteilhafter Weise wird ein örtlich begrenzter Gasstrahl erzeugt und das Substrat mittels einer Transportvorrichtung, z. B. mittels einer Schwenkvorrichtung in den Gasstrom zwecks Beschichtung hineintransportiert. Auf diese Weise ist es auf einfache Weise möglich, das Substrat zunächst in einem kühlen Bereich zu lagern und es erst unmittelbar vor Durchführung der Beschichtung in den heißen Gasbereich hineinzubewegen. Sobald der Beschichtungsvorgang abgeschlossen ist, wird die Gaszufuhr beendet oder das Substrat wieder heraustransportiert. Auf diese Weise ist es problemlos möglich, große Temperaturunterschiede von 100 K und mehr zwischen Substrat und Gas während des Beschichtungsvorganges aufrechtzuerhalten. Die Bauelementestrukturen bleiben besonders gut erhalten. Das Herausbewegen ist im Vergleich zur Beendigung der Gaszufuhr besonders vorteilhaft, da die Handhabung besonders einfach ist, sehr schnell der heiße Bereich wieder verlassen werden kann und außerdem problemlos eine kontinuierliche Prozeßführung (nacheinander werden mehrere Substrate beschichtet) möglich ist. Bei einer kontinuierlichen Prozeßführung sind translatorisch wirkende Bewegungsmittel (z. B. in der Art eines Fließbandes) von Vorteil.

Vorteilhaft befindet sich das Substrat während der Beschichtung unmittelbar vor der Öffnung (der Abstand betrage weniger als 5 mm, insbesondere weniger als 2 mm, z. B. 0,5 bis 1 mm), aus dem das heiße Gas austritt. Auf diese Weise wird der Materialverlust minimiert. Darüber hinaus ist es so möglich, diese Beschichtung vorteilhaft unter Vakuum durchzuführen.

Reinheitsanforderungen können dann problemlos erfüllt werden, und es ist dann beispielsweise möglich, die Schicht mittels Elektronenspektroskopie zu analysieren.

Es zeigen
Figur 1: Aufbau einer Beschichtungsapparatur
Figur 2 bis 6: Untersuchungsergebnisse

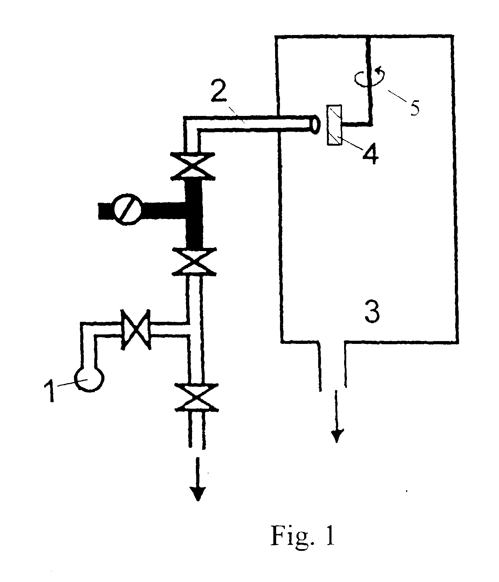

Gemäß Figur 1 wird das TEOS-Gas aus dem Vorratsbehälter 1 (in dem es flüssig ist) als Gas durch ein Begasungsrohr 2 in das Vakuumsystem 3 zum Substrat 4 hingeleitet, wobei der Abstand zwischen Rohröffnung und Substrat 4 ca. 0.5 - 1.0 mm beträgt. Der Druck im Begasungsrohr 2 liegt bei ca. 10⁻³ mbar. Die Temperatur des Rohres 2 wird durch eine elektrische Heizung auf 850 - 1100 K erhöht. Damit wird ebenfalls die Temperatur des durchströmenden Gases eingestellt. Wenn das Probe Substrat 4 vor die Öffnung des Begasungsrohres 2 mit ausströmendem Gas gestellt wird, beginnt die Abscheidereaktion des TEOS auf der Oberfläche, unabhängig von der Temperatur des Substrates 2 (getestet für 400 bis 1000 K). Die Abscheidegeschwindigkeit steigt mit wachsender Gastemperatur. Die Beschichtung wird durch Wegschwenken des Substrates 2 beendet. Hierfür ist das Schwenkmittel 5 vorgesehen. Die Abscheidung kann im Vakuum vorgenommen werden.

Vor und nach der Beschichtung wird das Substrat 2 auf ihren chemischen Zustand untersucht. Als Referenzsysteme werden im Gasphasenreaktor (sowohl in O₂ wie auch TEOS) hergestellte SiO₂ Schichten herangezogen.

Verfahrensgemäß ist eine Herstellung von SiO₂-Passivierungsschichten auf Silizium oder anderen Materialien aus der Ausgangssubstanz Tetraethoxysilan (TEOS) unter sehr reinen Vakuumbedingungen und niedrigen Substrattemperaturen zwischen 300 und 700 K möglich.

Im Vergleich zu den technisch üblichen Abscheideverfahren in einem TEOS Gasphasenreaktor, der bei ca. 970 - 1100 K betrieben wird, ist hier die Abscheidetemperatur des Substrats um bis zu 670 K geringer. Diese Temperaturerniedrigung ist wesentlich für die SiO₂ Beschichtung hochintegrierter Halbleiterbauelemente, damit Dotierungsprofile und geometrische Strukturen während der Passivierung mit SiO₂ erhalten bleiben.

Die unter reinen Vakuumbedingungen bei mindestens 700 K erzeugten SiO₂-Schichten sind in der Stöchiometrie, der Si-Oxidationsstufe und der Zersetzungstemperatur des Oxids nicht von bei hohen Temperaturen im Gasphasenreaktor erzeugten SiO₂-Schichten zu unterscheiden.

Die Beschichtung des Substrats findet in einem Vakuumsystem statt, in dem die chemische Reinheit und Zusammensetzung der Oxidschicht mit Röntgen-Photoelektronenspektroskopie (XPS oder ESCA) bzw. mit der Augerelektronenspektroskopie (AES) bestimmt werden kann.

Das Verfahren der SiO₂-Beschichtung beruht im Prinzip auf einer Entkopplung der Temperaturen von Substrat (=Probe) und TEOS-Gas. Während das Gas auf die thermodynamisch notwendige Zersetzungstemperatur erhitzt wird, kann die Probentemperatur, eventuell durch Kühlung, auf beliebige Werte zwischen 300 K und z.B. 1000 K oder höher eingestellt werden. Die Trennung der Temperaturen wird technisch dadurch verwirklicht, daß ein erhitzter Gasstrahl im Vakuum auf das kältere Substrat geleitet wird.

Das Verfahren zur Abscheidung von SiO₂ Schichten aus TEOS im Vakuum wird hier für das Substrat Si(100) bei verschiedenen Temperaturen demonstriert. Es werden drei verschiedene, sich ergänzende Experimente vorgeführt:
a) Substrat anfangs bei Raumtemperatur, variable Gastemperatur, T_{gas}, konstante Gaszugabe.
b) Substrat bei anfangs Raumtemperatur, Gastemperatur bei 970 K, Zeitabhängigkeit der Schichtbildung.
c) Substrat bei 1000 K, Gastemperatur bei 970 K, Zeitabhängigkeit.

### a) Substrat bei Raumtemperatur, variable Gastemperatur

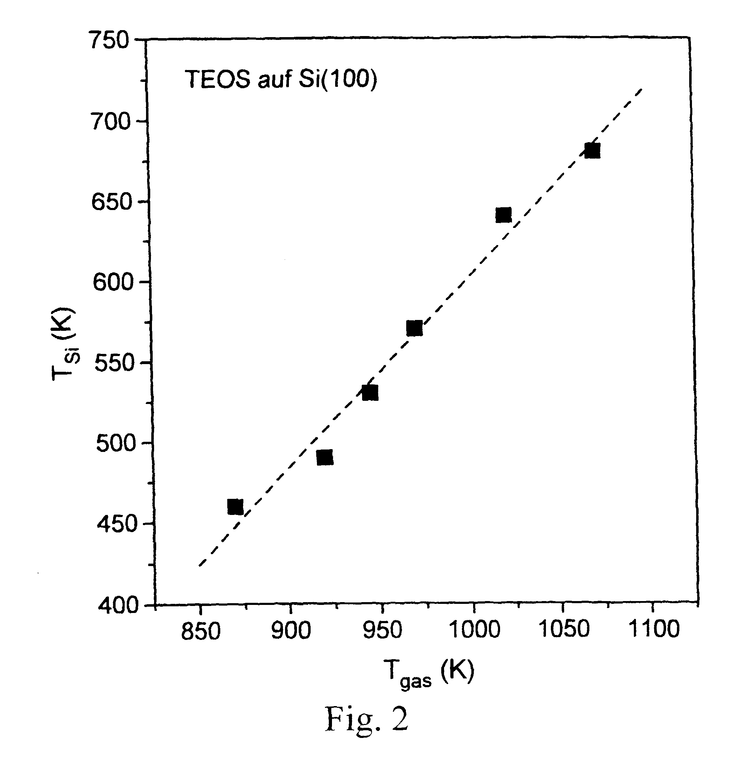

Die anfangs bei Raumtemperatur befindliche Si(100) Probe wurde für 10 min vor den Gasstrahl, der auf die Temperatur T_{gas} erhitzt wurde, geschwenkt. Die Abscheidung einer Oxidschicht setzte ein. Die Probentemperatur stieg dabei auf einen von T_{gas} abhängigen stationären Wert T_{Si}, wie aus Fig. 2 zu ersehen ist. Dieser Wert ist um ca. 400 K niedriger als T_{gas}. Diese Differenz ist charakteristisch für den Probenhalter der verwendeten Apparatur und kann durch Kühlen oder Heizen beliebig verändert werden.

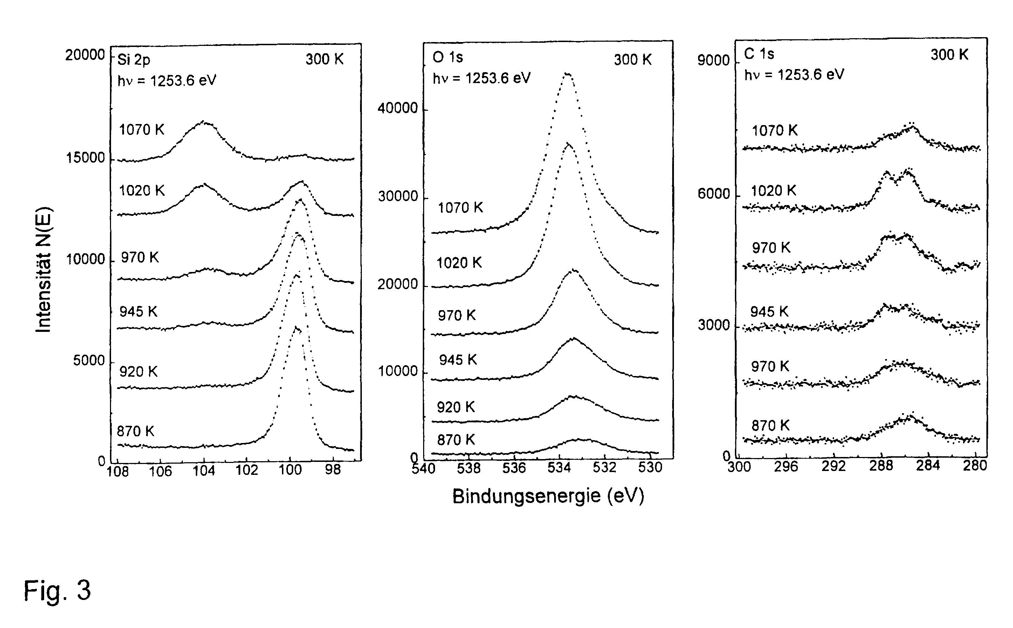

Für ein konstant gehaltenes Gasangebot von 1.9 mbar/s TEOS sind in Fig. 3 die Si 2p, O 1s und C 1s Photoelektronenlinien gezeigt, für jeweils verschiedene Tgas . Aus der Intensität der Si 2p Linie bei 104.2 eV und der 0 1s Linie kann die Menge des abgeschiedenen Oxids bestimmt werden. Ebenso aus der Dämpfung des Si 2p Elementsignals kann die Schichtdicke abgeschätzt werden. Die C 1S Intensitäten zeigen an, daß in Abhängigkeit von T_{gas} unterschiedliche Mengen von Kohlenstoff eingelagert werden.

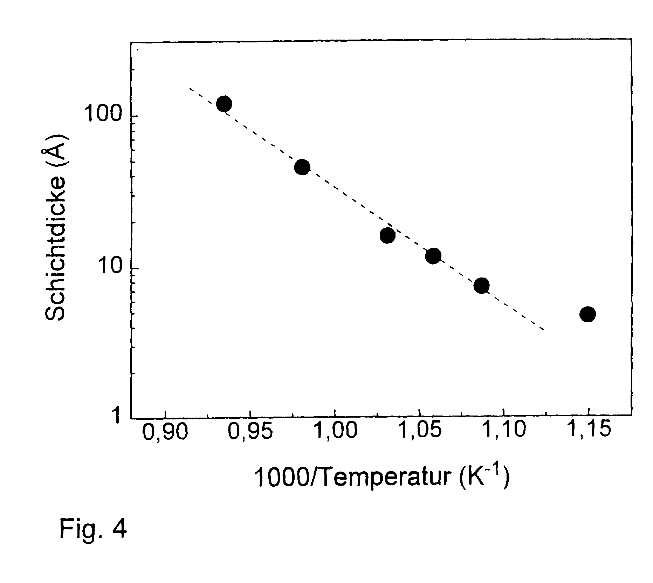

Die Abscheidegeschwindigkeit Δz/Δt der Oxidschicht ist exponentiell von T_{gas} abhängig, wie aus der Auftragung der Schichtdicke (proportional zu Δz/Δt bei konstanter Zeit Δt) gegen Tgas in Fig. 4 zu erkennen ist.

Gute Bedingungen für die SiO₂ Abscheidung mit wenig eingebautem Kohlenstoff sind bei T_{gas} = 1070 K und entsprechend T_{Si} = 680 K. Die Abscheidegeschwindigkeit beträgt ca. 10 Å/min.

### b) Substrat bei Raumtemperatur, T_{gas} = 970 K

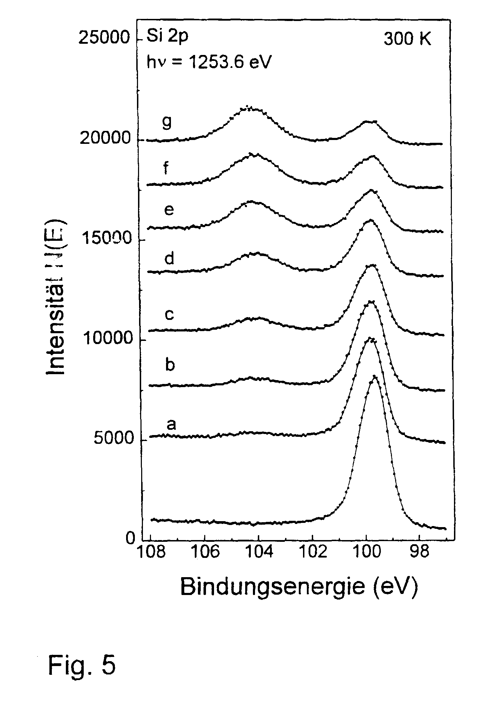

Das zeitliche Aufwachsen einer SiO₂ Schicht bei T_{gas} = 970 K und einer stationären Probentemperatur von 570 K ist in einer Sequenz von Si 2p Spektren in Fig. 5 festgehalten. Die Linie bei 104.2 eV zeigt das entstehende Oxid an.

### c) Substrat bei 1 000 K, T_{gas} = 970 K

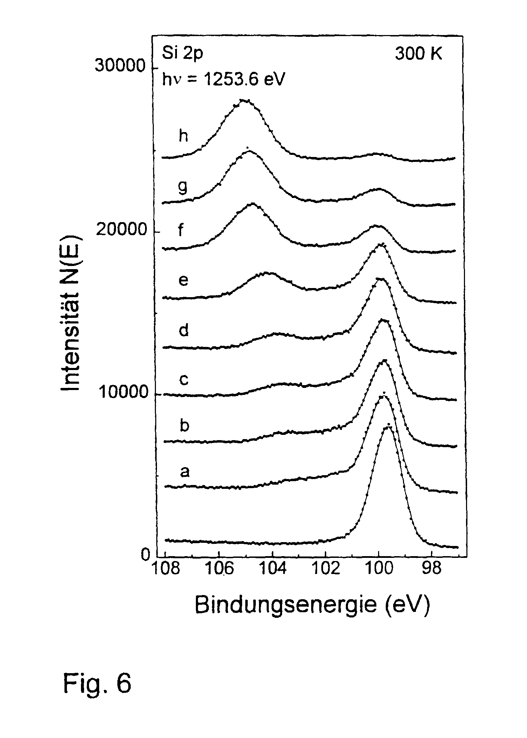

Eine ähnliche zeitliche Sequenz wie in Fig. 5 ist in Fig. 6 für eine hohe Substrattemperatur von 1000 K gezeigt. Es fällt auf, daß der oxidische Si 2p Peak anfangs bei tieferer Energie von 103.8 eV einsetzt und sich zu höheren Energien verschiebt. Dieses Verhalten deutet auf eine stöchiometrisch unscharfe Grenzfläche SiO₂/Si hin, da geringere Si 2p Bindungsenergien mit geringeren Oxidationsstufen des Siliziums verbunden sind. Die hohe Temperatur T_{Si} führt zu einer unerwünschten Interdiffusion von Si in SiO₂ und damit zu einer teilweisen Reduktion des SiO₂. Eine tiefere Temperatur T_{Si} ist für den Prozeß vorteilhafter.

## Patentansprüche

1. Verfahren zur Abscheidung einer Schicht auf der Oberfläche eines Substrates mit mikroelektronischen Strukturen wobei
a) ein das Schichtmaterial enthaltendes Gas mittels eines Begasungsrohres auf die Oberfläche mit den mikroelektronischen Strukturen zwecks Schichtabscheidung geleitet wird,
b) die Entfernung zwischen Substrat und der Öffnung des Begasungsrohres weniger als 5 mm beträgt,
c) die Schichtabscheidung unter Vakuum durchgeführt wird,
d) eine Entkopplung der Gas- und Substrattemperatur vorgenommen wird und
e) das Substrat aus einem kühlen Bereich in den aus dem Begasungsrohr austretenden heißen Gasstrom hineintransportiert und nach der Beschichtung wieder aus dem austretenden Gasstrom heraustransportiert wird.

2. Vorrichtung zur Abscheidung einer Schicht auf der Oberfläche eines Substrates mit mikroelektronischen Strukturen,
a) die ein Begasungsrohr (2) zur Lenkung eines heißen Gasstrahles auf die Oberfläche eines Substrates (4) aufweist,
b) bei der die Entfernung zwischen Begasungsrohröffnung und zu beschichtender Substratoberfläche weniger als 5 mm beträgt,
c) die ein Vakuumsystem, in dem die Beschichtung durchgeführt wird, aufweist,
d) mit Mitteln zur Entkopplung der Gas- und Substratoberflächentemperatur und
e) mit Mitteln zum Transport des Substrates derart, daß das Substrat aus einem kühlen Bereich in den heißen Gasstrom hineintransportiert und nach der Beschichtung wieder heraustransportiert werden kann.

## Claims

1. Process for depositing a coating on the surface of a substrate with microelectronic structures, wherein:
a) an aerating pipe is used to conduct a gas containing the coating material onto the surface with the microelectronic structures in order to deposit the coating,
b) the distance between the substrate and the aperture of the aerating pipe is less than 5 mm,
c) coating deposition is carried out in a vacuum,
d) decoupling of the gas temperature and the substrate temperature takes place, and
e) the substrate is transported out of a cool zone into the hot gas stream emerging from the aerating pipe and following the coating operation is transported back out of the emerging gas stream.

2. Apparatus for depositing a coating on the surface of a substrate with microelectronic structures,
a) the apparatus incorporating an aerating pipe (2) for directing a hot gas jet onto the surface of a substrate (4),
b) wherein the distance between the aerating pipe and the substrate surface to be coated is less than 5 mm,
c) the apparatus incorporating a vacuum system in which the coating operation is carried out,
d) having means for decoupling the gas temperature and the substrate surface temperature and
e) having means for transporting the substrate, in such a way that the substrate is transported out of a cool zone into the hot gas stream and can be transported back out again following the coating operation.

## Revendications

1. Procédé de dépôt d'une couche à la surface d'un substrat ayant des structures micro-électroniques, qui consiste
a) à envoyer un gaz renfermant la matière de la couche, au moyen d'un tube d'envoi de gaz sur la surface ayant les structures micro-électroniques, en vue du dépôt d'une couche,
b) la distance entre le substrat et l'orifice du tube d'envoi de gaz étant inférieure à 5 mm,
c) à effectuer le dépôt de la couche sous vide,
d) à prévoir un découplage de la température du gaz et de la température du substrat, et
e) à faire passer le substrat d'une région froide dans le courant de gaz chaud sortant du tube d'envoi de gaz et, après l'opération de revêtement, à le ressortir du courant de gaz qui sort du tube d'envoi de gaz.

2. Dispositif de dépôt d'une couche à la surface d'un substrat ayant des structures micro-électroniques,
a) qui comporte un tube (2) d'envoi de gaz, pour envoyer un jet de gaz chaud sur la surface d'un substrat (4),
b) dans lequel la distance entre l'orifice du tube d'envoi de gaz et la surface du substrat à revêtir est inférieure à 5 mm,
c) qui comporte un système sous vide dans lequel est effectuée l'opération de revêtement,
d) ayant des moyens de découplage de la température du gaz et de la température superficielle du substrat, et
e) ayant des moyens de déplacement du substrat de manière que le substrat puisse passer d'une région froide dans un courant de gaz chaud et, après l'opération de revêtement, puisse en être ressorti.
